Europäisches Patentamt

European Patent Office

Office européen des brevets

(11) Publication number: **0 411 138 A1**

# EUROPEAN PATENT APPLICATION
## published in accordance with Art. 158(3) EPC

(21) Application number: 90901679.2

(22) Date of filing: **10.01.90**

(86) International application number:
**PCT/JP90/00027**

(87) International publication number:
**WO 90/09056 (09.08.90 90/19)**

(51) Int. Cl.5: **H02M 7/537**

(30) Priority: **24.01.89 JP 14626/89**

(43) Date of publication of application:
**06.02.91 Bulletin 91/06**

(84) Designated Contracting States:
**DE FR GB**

(71) Applicant: **FANUC LTD.**
**3580, Shibokusa Aza-Komanba, Oshino-mura Minamitsuru-gun, Yamanashi 401-05(JP)**

(72) Inventor: **KOBAYASHI, Eiji Fanuc Mansion**

Harimomi 4-105
3536, Shibokusa Oshinomura
Minamitsuru-gun Yamanashi 401-05(JP)
Inventor: **EGAWA, Akira Fanuc Mansion**
Harimomi 3-303
1205, Shibokusa Oshinomura
Minamitsuru-gun Yamanashi 401-05(JP)

(74) Representative: **Brunner, Michael John et al**
**GILL JENNINGS & EVERY 53-64 Chancery Laneane**
**London WC2A 1HN(GB)**

(54) **INVERTER.**

(57) The invention relates to an inverter which is supplied with a DC power and performs the switching operation at a single frequency in response to predetermined drive signals (Vg1, Vg2, Vg3, and Vg4). The inverter is provided with a transmission transformer (CH) comprising two coils which have equal inductances and are magnetically closely coupled together. The two coils (CH1,CH2) are respectively inserted in a pair of lines that transmit an AC voltage, with their polarities being the same. The impedance of the transmission transformer (CH) is negligibly small with respect to a normal AC voltage of the positive phase mode. The harmonic voltages is of the in-phase mode, and the transmission transformer (CH) exhibits a very high impedance to the harmonic voltages, so that no current path is formed. Therefore, there is a decrease in the distortion of the waveforms of the voltages applied across the drains and sources of MOS transistors (FET1, FET2, FET3, and FET4), and the peak value decreases.

FIG. 1

## INVERTER DEVICE

Technical Field

This invention relates to an inverter device for converting a D.C. power to an A.C. power by switching a MOS transistor and outputting the same, and more particularly, to an inverter device capable of eliminating harmonic components of in-phase mode to be superposed on an output voltage.

This invention can be used as a power source for high-frequency discharge pumping $CO_2$ gas laser devices, high-frequency induction heating furnaces, or the like.

Background Art

Conventionally, an inverter device constructed to convert a D.C. power to an A.C. power of a desired frequency, by switching a MOS transistor and outputting the same, is used as a power source for high-frequency discharge pumping $CO_2$ gas laser devices or high-frequency induction heating furnaces.

A MOS transistor has a relatively large output capacitor existing between the drain and source thereof. This output capacitor is parasitically created when the transistor is formed and causes a power loss when a high-frequency operation is effected, and further, resonates with the inductance of a wiring to generate harmonics.

These harmonics are transmitted via a stray capacitor between the drain of the MOS transistor and the ground and a stray capacitor between the primary and secondary windings of a matching insulating transformer connected between the MOS transistor and a load; i.e., it is superposed on an output A.C. voltage in the in-phase mode.

As a result, the peak value of a voltage waveform applied between the drain and source of the MOS transistor is raised and the input D.C. voltage level is limited, making it impossible to derive a sufficient output power.

Disclosure of the Invention

This invention has been made in view of the above fact, and an object thereof is to provide an inverter device which is small and can eliminate harmonic components of an in-phase mode to be superposed on an output voltage, and generate a high power at a high efficiency.

To solve the above problem, in this invention, there is provided an inverter device which comprises one set of input terminals connected to a D.C. power source, one set of output terminals connected to a load, an inductance element connected in series with at least one of the input terminals, at least one MOS (metal-oxide-semiconductor) transistor connected in series with the induction element and the other of the input terminals, for effecting a switching operation at a single frequency in response to a preset driving signal to output an A.C. voltage, and an insulating transformer for insulating a direct current component of the A.C. output voltage and outputting the same to the output terminals, the device being characterized in that a transmission transformer having two coils, which have the same inductance and are magnetically closely coupled with each other, is provided and the two coils of the transmission transformer are connected with the same polarities to respective ones of one set of lines for transmitting the A.C. voltage.

The impedance of the transmission transformer is so small that it is negligible with respect to a normal A.C. voltage of positive phase mode, but the harmonic voltage is in the in-phase mode and the transmission transformer exhibits an extremely high impedance with respect to the harmonic voltage and prevents the creation of a current path. As a result, the waveform distortion of a voltage applied between the drain and source of the MOS transistor is reduced and the peak value is reduced.

Brief Description of the Drawings

Fig. 1 is a circuit diagram of an inverter device according to one embodiment of this invention;

Fig. 2 is an equivalent circuit diagram of an inverter device according to one embodiment of this invention; and

Fig. 3 is a diagram showing the waveform of a voltage applied between the drain and source of a MOS transistor.

Best Mode of Carrying Out the Invention

An embodiment of this invention will now be described with reference to the accompanying drawings.

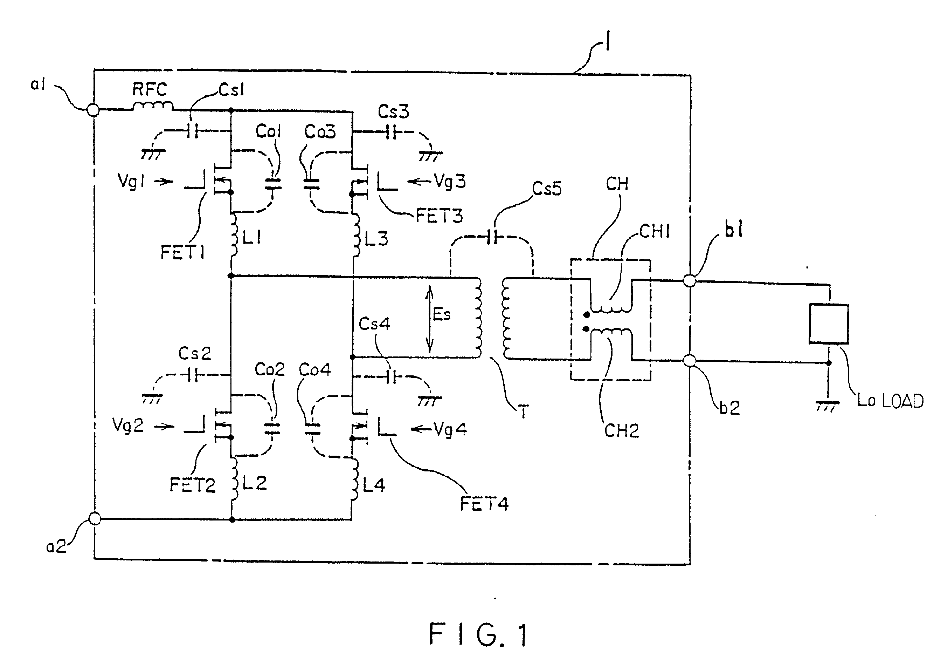

Figure 1 is a circuit diagram of an inverter device according to one embodiment of this invention. In Fig. 1, a D.C. power source is connected to input terminals a1 and a2 of an inverter device 1, to supply a preset D.C. voltage to N-channel MOS transistors FET1 to FET4 via a choke coil RFC. The MOS transistors are fixed on a heat sink connected to the earth via an insulative film. The base portions of the MOS transistors correspond to drains, and therefore, stray capacitors Cs1 to Cs4 exist between the drains and the ground.

The respective gates of the MOS transistors FET1 to FET4 are supplied with driving signals Vg1 to Vg4. The driving signals Vg1 and Vg4 are the same signal and the driving signals Vg2 and Vg3 are the same signal, and the two types of driving signals are shifted in phase from each other by $180°$. With this arrangement, the MOS transistors FET1 and FET4 and the MOS transistors FET2 and FET3 are alternately turned on and off to generate a harmonic A.C. voltage Es, permitting a current to flow in a load Lo connected to output terminals b1 and b2 via an insulating transformer T and a transmission transformer CH. The load Lo is a discharge tube of a high-frequency discharge pumping $CO_2$ gas laser, a high-frequency induction heating furnace, or the like.

On the other hand, a harmonic voltage Eh of an in-phase mode (not shown) is generated at each switching operation by output capacitors Co1 to Co4 of the MOS transistors FET1 to FET4 and inductances L1 to L4 of wirings.

In this case, coils CH1 and CH2 of the transmission transformer CH have the same inductance and are magnetically closely coupled with each other and inserted into the lines with the same polarities. Therefore, the impedance thereof is so small that it is negligible with respect to a voltage of the positive phase mode but is extremely high with respect to a voltage of the in-phase mode.

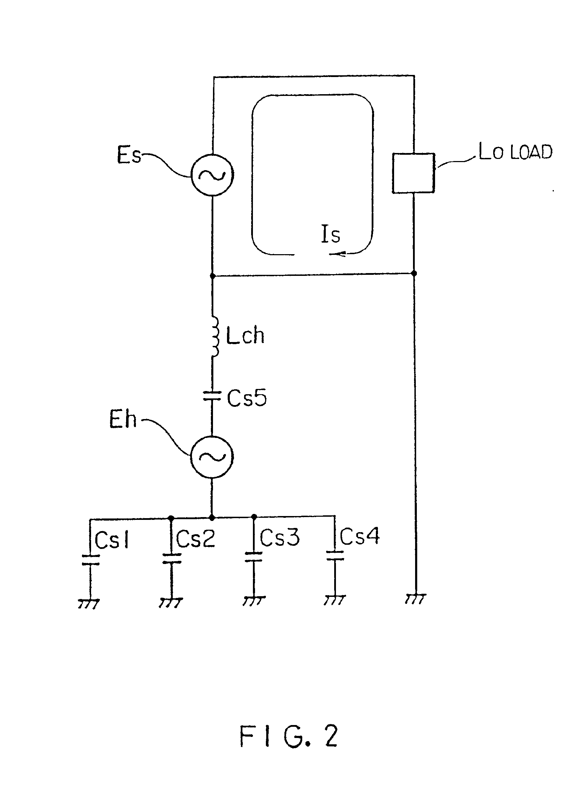

The relationship between the A.C. voltage Es and the harmonic voltage Eh is explained with reference to an equivalent circuit shown in Fig. 2. In this case, various constants such as impedance and resistors in the positive phase mode are omitted. In Fig. 2, the A.C. voltage Es is applied to the load Lo, permitting a current Is to flow.

The harmonic voltage Eh is coupled to a current path of the A.C. voltage Es via a parallel circuit of the stray capacitors Cs1 to Cs4 of the MOS transistors FET1 to FET4, and a series circuit of a stray capacitor Cs5 between the primary and secondary windings of the insulating transformer T and an inductance Lch of the transmission transformer for the in-phase mode.

Nevertheless, as described before, since the value of the inductance Lch is extremely large, in practice a current due to the harmonic voltage Eh does not flow. Namely, the harmonic voltage Eh is not superposed on the A.C. voltage Es.

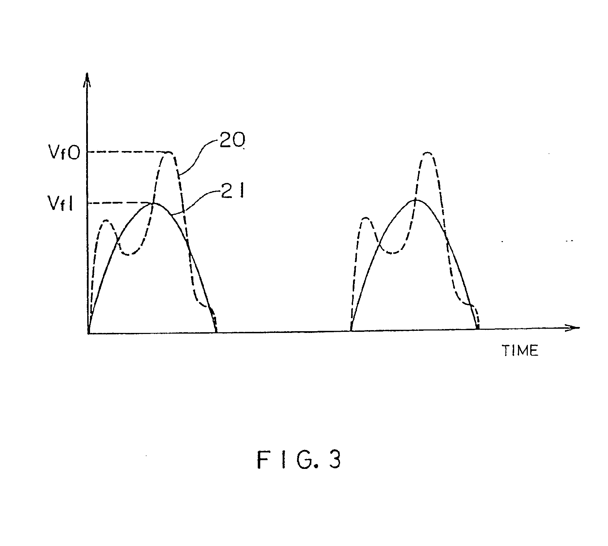

Figure 3 is a graph showing the waveform of a voltage between the drain and source of the MOS transistor. In Fig. 3, 20 denotes a voltage waveform which is obtained in the conventional inverter device and on which a harmonic of in-phase mode is superposed. In contrast, a voltage waveform 21 obtained in the inverter device according to one embodiment of this invention is substantially a sinusoidal wave, and the peak value Vf1 of the voltage waveform is lowered to approx. 3/4 of the peak value Vf0 of the voltage waveform 20.

Therefore, it becomes possible to raise the input D.C. voltage level in comparison with the prior art case, permitting a larger output power to be produced.

Further, in the above explanation, the transmission transformer is connected between the secondary side of the insulating transformer and the load, but it is also possible to connect the transmission transformer between the MOS transistor and the primary side of the insulating transformer, to reduce the peak value of the waveform of a voltage between the drain and source of the MOS transistor in the same manner as described above.

As described above, according to this invention, since the transmission transformer is connected to the lines for transmitting an A.C. voltage, to exhibit a high impedance only for the in-phase mode current, harmonics will not be superposed on the A.C. voltage and the peak value of a voltage applied between the drain and source of the MOS transistor is reduced. As a result, the input D.C. voltage level can be raised in comparison with the conventional case, to thereby enhance the output and efficiency of the inverter device.

## Claims

1.  An inverter device comprising one set of input terminals connected to a D.C. power source; one set of output terminals connected to a load; an inductance element connected in series with at least one of said input terminals; at least one MOS (metal-oxide-semiconductor) transistor connected in series with said induction element and the other of said input terminals, for effecting a switching operation at a single frequency in response to a preset driving signal to output an A.C. voltage; and an insulating transformer for insulating a direct current component of the A.C. output voltage and outputting the same to said output terminals,

    characterized in that a transmission transformer having two coils which have the same inductance and are magnetically closely coupled with each other is provided; and

    said two coils of said transmission transformer are connected with the same polarities to respective ones of one set of lines for transmitting the A.C. voltage.

2. An inverter device according to claim 1, characterized in that said two coils of said transmission transformer are connected between the secondary side of said insulating transformer and said output terminals.

3. An inverter device according to claim 1, characterized in that said two coils of said transmission transformer are connected between said MOS transistor and the primary side of said insulating transformer.

F I G. 1

EP 0 411 138 A1

FIG. 2

F I G. 3

# INTERNATIONAL SEARCH REPORT

International Application No  PCT/JP90/00027

| I. CLASSIFICATION OF SUBJECT MATTER (if several classification symbols apply, indicate all) 6 |
|---|

According to International Patent Classification (IPC) or to both National Classification and IPC

Int. Cl⁵      H02M7/537

## II. FIELDS SEARCHED

Minimum Documentation Searched 7

| Classification System | Classification Symbols |
|---|---|
| IPC | H02M7/48, 7/537, 7/5387 |

Documentation Searched other than Minimum Documentation
to the Extent that such Documents are Included in the Fields Searched 8

| | |
|---|---|
| Jitsuyo Shinan Koho | 1971 – 1990 |
| Kokai Jitsuyo Shinan Koho | 1971 – 1990 . |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | JP, A, 58-89075 (Hitachi, Ltd.), 27 May 1983 (27. 05. 83), (Family: none) | 1 |
| A | JP, U, 60-79292 (JEOL Ltd.), 1 June 1985 (01. 06. 85), (Family: none) | 1, 2 |
| A | JP, U, 55-56488 (Meidensha Electric Mfg. Co., Ltd.), 16 April 1980 (16. 04. 80), (Family: none) | 2, 3 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| March 20, 1990 (20. 03. 90) | April 2, 1990 (02. 04. 90) |
| International Searching Authority | Signature of Authorized Officer |
| Japanese Patent Office | |

Form PCT/ISA/210 (second sheet) (January 1985)